Europäisches Patentamt

(19) European Patent Office

Office européen des brevets

(11) Publication number: **0 439 351 A1**

(12) **EUROPEAN PATENT APPLICATION**

(21) Application number: 91300532.8

(51) Int. Cl.[5]: **H01L 39/24, H01L 39/12**

(22) Date of filing: **24.01.91**

(30) Priority: **26.01.90 JP 17114/90**

(43) Date of publication of application:
**31.07.91 Bulletin 91/31**

(84) Designated Contracting States:
**DE FR GB**

(71) Applicant: **SHARP KABUSHIKI KAISHA**
**22-22 Nagaike-cho Abeno-ku**
**Osaka (JP)**

(72) Inventor: **Taniguchi, Hiroshi**
**2-506, Nara high town, 606-76, Sanjo-cho**
**Nara-shi, Nara (JP)**
Inventor: **Nojima, Hideo**
**203, Wakakusa heights, 65-10,**
**Minaminagai-cho**
**Nara-shi, Nara (JP)**
Inventor: **Koba, Masayoshi**
**1-51-14-5, Shichijonishi-machi**
**Nara-shi, Nara (JP)**

(74) Representative: **West, Alan Harry et al**
**R.G.C. Jenkins & Co. 26 Caxton Street**
**London SW1H 0RJ (GB)**

(54) Oxide superconductor material and device.

(57) There is described a new Y-Ba-Cu-O oxide superconductor, in which one of the constituent metallic elements is partially substituted by a metallic element of lower valence. The degree of substitution can be such that the resulting crystal lattice constant matches that of a substrate (2) to which a film (12) of the oxide superconductor is applied to render the substrate and film compatible. Various structures of devices containing such compatible substrate (2)/film (12) combinations are described also.

EP 0 439 351 A1

# OXIDE SUPERCONDUCTOR MATERIAL AND DEVICE

This invention relates to an oxide superconductor material and to a device incorporating it.

Y-Ba-Cu-O oxide superconductors of the composition $Y_1Ba_2Cu_3O_{7-\delta}$ have been proposed as high temperature superconductors. Generally, they have critical temperatures higher than the boiling point of liquid nitrogen, and the problems associated with cooling in order to achieve their superconducting characteristics are therefore reduced. Consequently, such materials are expected to find wide application in the electronics industry.

Such oxide superconductors have a layered perovskite crystal structure, so that their superconducting characteristics have remarkable anisotropy. For example, the upper critical magnetic field can differ by a factor of three to ten depending upon whether the magnetic field is applied in the c-axis direction or in perpendicular to the c-axis direction, and the critical current density can differ by a factor of one hundred in the two cases. In the areas of power electronics and of microelectronics utilising thin films, it is therefore necessary to enhance the crystal orientation of the oxide superconductor film in order for the film to endure use at high electric current densities.

In the electronics field, oxide superconductors are generally used as thin films deposited on suitable substrates. Efforts are made to manufacture such thin films with perfect c-axis orientation by appropriate selection of the substrate.

In the case of yttrium oxide superconductors, $SrTiO_3$ (100) which has relatively approximate lattice constants is considered to be the most suitable substrate material. However, strictly speaking, even this substrate has a mismatched lattice constant of about 2%, so that the c-axis orientation of the oxide superconductor thin film cannot be said to be entirely sufficient.

The present invention seeks to provide an yttrium oxide superconductor film having a more satisfactory crystal orientation.

According to the invention, a Y-Ba-Cu-O type oxide superconductor has one of its constituent metallic elements partially substituted by a metallic element of lower valence.

Also according to the invention, an oxide superconductor device comprises a substrate and a film of oxide superconductor deposited on the substrate, the film comprising a first layer applied to the substrate and a second layer deposited on the first layer, the first layer being a Y-Ba-Cu-O type oxide superconductor having one of its constituent metallic elements partially substituted by a metallic element of lower valence in amounts corresponding to a first value at the interface with the substrate and a second value at the interface with the second layer, the first value corresponding with the lattice constants of the substrate and the second value corresponding with the lattice constants of the second layer.

The present invention takes advantage of the facts that the lattice constants of a Y-Ba-Cu-O type oxide superconductor film can be changed continuously, and that an oxide film of good superconducting characteristics can then be formed on a substrate with matching lattice constants.

The present invention is described below in greater detail by way of example only with reference to the accompanying drawings, in which

Figure 1(a) is a perspective view of the crystal structure of yttrium oxide superconductor and Figure 1(b) is a diagram which shows the directions of the crystal axes ;

Figure 2 is a plot of the temperature dependence of electrical resistance of oxide superconductors of the invention ;

Figure 3 is a plot of the lattice constant against the amount of calcium substituting yttrium in the oxide superconductors ;

Figures 4, 5 and 6 are schematic sectional views of oxide superconductor devices of the invention.

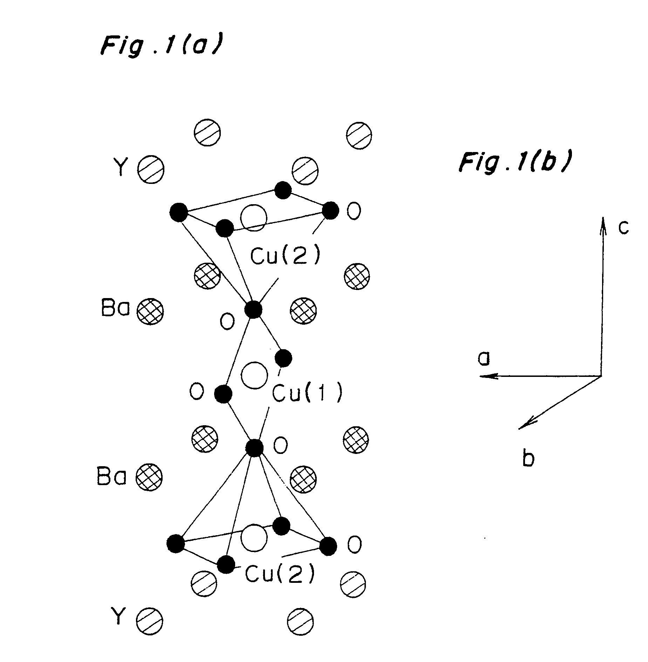

Referring to Figures 1(a) and 1(b) of the drawings, a Y-Ba-Cu-O oxide superconductor has a rhombohedral crystal structure of layered perovskite. Figure 1(a) is a perspective view showing the arrangement of constituent elements in the yttrium oxide superconductor crystal, while Figure 1(b) shows the crystal axes.

In the crystal structure shown in Figures 1(a) and 1(b), copper atoms exist in two different sites : one shown as Cu(1) forms linear Cu-O chains along the b-axis, while the other shown as Cu(2) forms two-dimensional $CuO_2$ planes. It is known that conduction holes in the superconducting state are supplied from oxygen atoms coordinating with Cu(1).

According to the invention, a part of a constituent metallic element of the oxide superconductor is replaced with another element such as an alkali metal or an alkaline earth metal. Thus, conduction holes are supplied by the substituting atoms and the lattice constants are changed according to the degree of substitution.

For example, by substituting the trivalent Y sites partially by divalent calcium ions having an ionic radius corresponding to that of trivalent yttrium ions, a new oxide superconductor system Y-Ca-Ba-Cu-O is manufactured. Also, by substituting the divalent Ba sites partially by monovalent potassium ions having an ionic radius corresponding to that of divalent Ba ions, a new oxide superconductor system Y-Ba-K-Cu-O is manufactured. In such oxide superconductors, the lattice constants are changed while conduction holes are supplied according to the difference between the valencies of the original element and the substituting element. Therefore, the lattice constants can be matched perfectly with a substrate, and an yttrium oxide superconductor can be properly connected to a substrate without generating strain, by gradating the amount of substituting elements continuously or in regular steps from the interface with the substrate.

Oxide superconductors are prepared by solid state reaction using powder materials of $Y_2O_3$, $CaCO_3$, $BaCO_3$ and $CuO$. In order to illustrate the invention, three different superconductor materials A, B and C are prepared by varying the proportions of the starting materials ; the ratios of Y, Ca, Ba and Cu in the starting materials is 1 :0 :2 :3 for A, 1 :0.05 :2 :3 for B and 1 :0.1 :2 :3 for C.

After being mixed, the powder materials are fired preliminarily at 900°C for six hours and then at 920°C for six hours and are finally subjected to heat treatment at 400°C for fifteen hours.

By examining the resulting superconductors by X-ray microanalysis, it is found that the amounts of calcium atoms actually substituting yttrium atoms are 0, 6 and 11 at% in A, B and C, respectively.

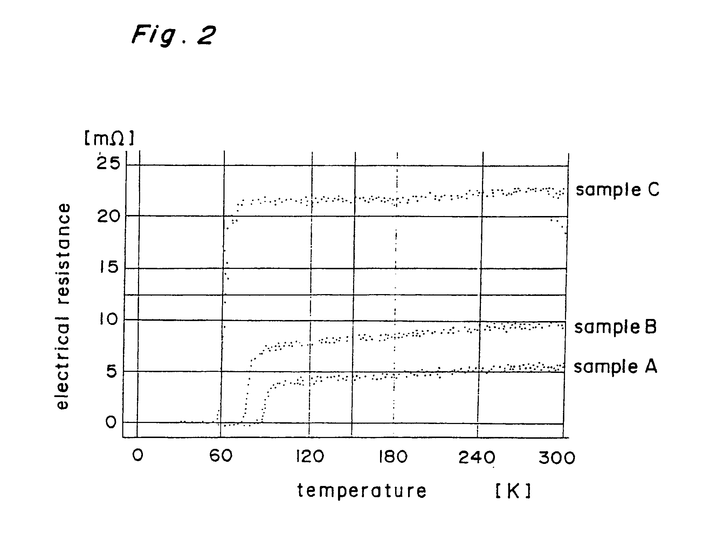

Figure 2 shows the results of measurements of temperature dependence of the electrical resistance of the superconductors prepared above. The transition temperature $T_C$ is 89°K for A, 79°K for B and 60°K for C, that is, it is confirmed that $T_C$ decreases with increasing calcium content and that although $T_C$ decreases, the materials still exhibit superconducting characteristics.

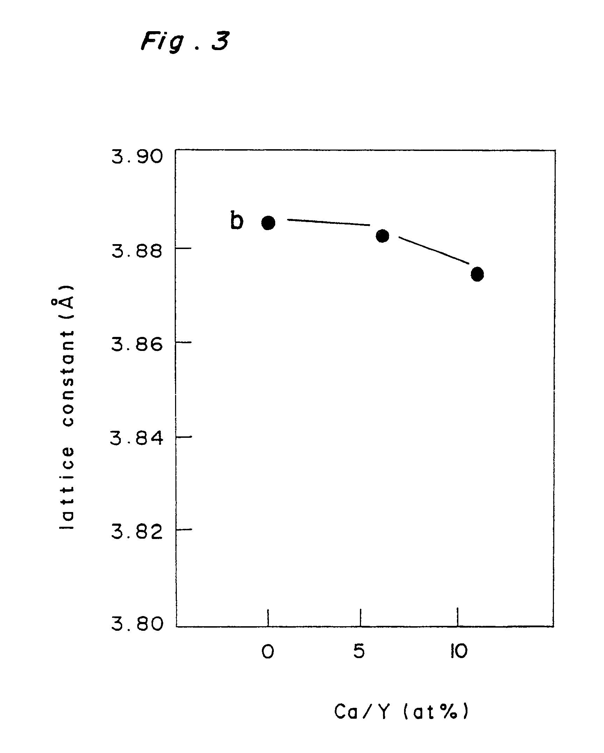

By examining X-ray diffraction patterns of the superconductors, it is confirmed that A, B and C all have the rhombohedral crystal structure of yttrium oxide superconductors. However, as shown in Figure 3, the b-axis lattice constant calculated from the X-ray diffraction angles decreases with increasing calcium content. This shows that the b lattice constant can be controlled by changing the amount of calcium added for substituting yttrium.

Therefore, when an oxide superconducting film is deposited on a substrate, compatibility of the film with the substrate can be improved by adding calcium around the interface with the substrate in order to match the lattice constants with those of the substrate. By reducing the amount of calcium continuously or stepwise away from the interface, it is possible to form an oxide superconductor film of c-axis orientation having good characteristics.

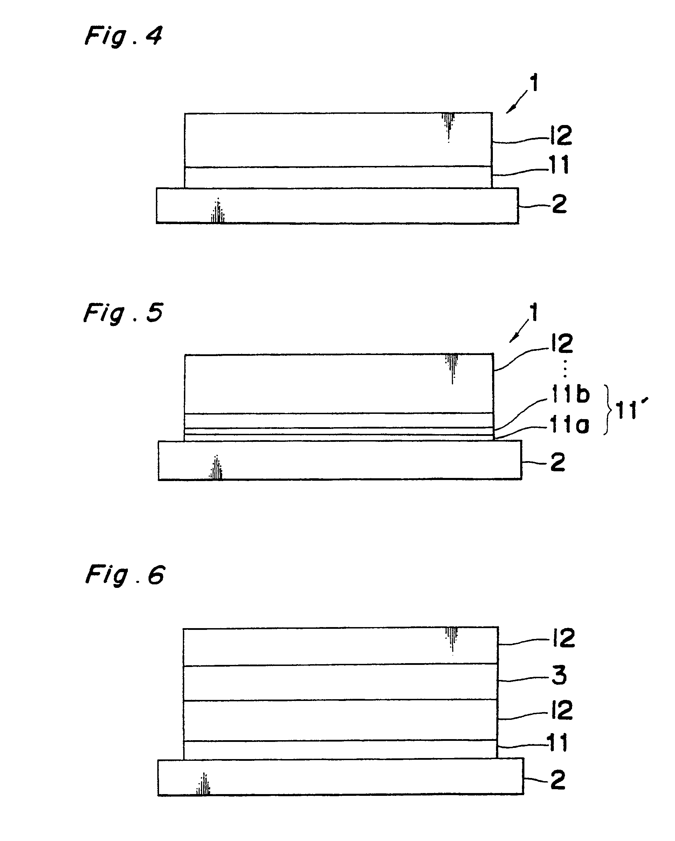

As shown in Figures 4 and 5, an oxide superconductor film 1 of c-axis orientation formed on a substrate 2 for example of $SrTiO_3$, includes two layers 11/11' and 12. The first layer 11/11' deposited on the substrate 2 has a lattice constant of the same value as the lattice constant of the substrate 2 at the interface with the substrate 2 and a lattice constant of the same value as the lattice constant of the second layer 12 at the interface with the second layer 12. The second layer 12 is of high $T_C$ Y-Ba-Cu-O oxide superconductor. In the case of Figure 4, the lattice constant in the layer 11 changes continuously, while in the cases of Figure 5, the layer 11' consists of a plurality of sublayers 11a, 11b, ..., each having a lattice constant different from the other sublayers, so that the lattice constant through the layer 11' changes stepwise. As explained above, the lattice constant in the layer 11/11' is controlled by the amount of calcium.

For manufacturing a thin film 1 of an oxide superconductor described above, an ordinary thin film technique such as sputtering, vacuum deposition or chemical vapor deposition can be used. By using a deposition apparatus in which the amount of added calcium can be controlled, the necessary amount of calcium is added on deposition at the interface with the substrate 2 and then the amount of calcium to be added is decreased. Then, the matching of lattice constants with the substrate 2 prevents the generation of strain or the like, while a film of the second layer 12 to be used for the superconducting characteristics remote from the substrate 2 has a high $T_C$. Therefore, an oxide superconductor film of good crystal axis orientation can be manufactured so that the film has a critical current of high current density.

A multi-layer oxide superconductor structure as shown in Figure 6 can be manufactured by interposing an insulator film 3 between two oxide superconductor films 12 using the method described above.

Still further, as well as substituting yttrium with calcium as described above, the lattice constants can be controlled similarly by adding another alkali metal or alkaline earth metal.

According to the invention, an oxide superconductor film of good characteristics can be formed on a substrate having lattice constants which do not match with those of the film. Thus, a high $T_C$ oxide superconductor film can find electronics applications. Further, various electronics devices can be manufactured by layering the superconductor with an electronic material such as a semiconductor or an insulator. For example, an oxide superconductor can be applied to a superconductor sensor element, an electronics device, metallization in an integrated circuit, or the like.

## Claims

1. A Y-Ba-Cu-O type oxide superconductor, wherein one of its constituent metallic elements is partially substituted by a metallic element of lower valence.

2. An oxide superconductor according to claim 1, wherein the lower valent metallic element is an alkaline earth metal.

3. An oxide superconductor according to claim 2, wherein the alkaline earth metal is calcium.

4. An oxide superconductor according to claim 1, wherein the lower valent metallic element is an alkali metal.

5. An oxide superconductor according to claim 4, wherein the alkali metal is potassium.

6. An oxide superconductor device, comprising a substrate and a film of oxide superconductor deposited on the substrate, the film comprising a first layer deposited on the substrate and a second layer deposited on the first layer, the first layer being a Y-Ba-Cu-O type oxide superconductor according to any one of claims 1 to 5 in which the amount of lower valent metallic element corresponds to a first value at the interface with the substrate and a second value at the interface with the second layer, the first value corresponding with the lattice constants of the substrate and the second value corresponding with the lattice constants of the second layer.

7. An oxide superconductor device according to claim 6, wherein the amount of lower valent metallic element in the first layer changes continuously between the two interfaces.

8. An oxide superconductor device according to claim 6, wherein the first layer is composed of a plurality of sublayers and the amount of lower valent metallic element differs in each sublayer so that the lattice constant changes stepwise between the two interfaces.

*Fig .1(a)*

*Fig .1(b)*

## Fig. 2

*Fig . 3*

*Fig . 4*

*Fig . 5*

*Fig . 6*

European Patent
Office

# EUROPEAN SEARCH REPORT

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | MATERIALS RESEARCH BULLETIN. vol. 23, 1988, OXFORD GB pages 1241 - 1246; Y. MATSUMOTO ET AL: "Superconducting Y1-xLxBa2-yMyCu3-zNzOd system with higher Tc than 77K" * page 1242 * | 1-5 | H01L39/24 H01L39/12 |
| Y |  | 6, 8 |  |
| Y | EP-A-0300863 (THOMSON-CSF) * column 2, lines 12 - 43; figures 1, 2 * * column 3, line 61 - column 4, line 11 * | 6, 8 |  |
| X | JOURNAL OF MATERIALS SCIENCE LETTERS. vol. 8, no. 11, November 1989, LONDON GB pages 1271 - 1273; T. SUZUKI ET AL: "Composition dependence of superconductivity in the YBa2-xMxCu3Oy system" * page 1271 * | 1-5 |  |
| X | MATERIALS LETTERS vol. 7, no. 11, February 1989, AMSTERDAM NL pages 375 - 379; Z. TOMKOWICZ ET AL: "Influence of different elements on the superconducting properties of the YBa2Cu3Ox compound" * pages 375 - 376 * | 1-5 | TECHNICAL FIELDS SEARCHED (Int. Cl.5) H01L |
| X | APPLIED PHYSICS LETTERS. vol. 56, no. 2, 08 January 1990, NEW YORK US pages 183 - 185; M. R. CHANDRACHOOD ET AL: "Calcium substitution at yttrium site in YBa2Cu3Oy" * page 183 * * table I * | 1-3 |  |
| A | PATENT ABSTRACTS OF JAPAN vol. 13, no. 84 (C-572)( ) 27 February 1989, & JP-A-63 270395 (CHICHIBU CEMENT) 08 November 1988, * the whole document * | 6 |  |

The present search report has been drawn up for all claims

| Place of search | Date of completion of the search | Examiner |
|---|---|---|
| BERLIN | 12 APRIL 1991 | ROUSSEL A.T. |

European Patent
Office

EUROPEAN SEARCH REPORT

Application Number

EP    91 30 0532
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| A | PATENT ABSTRACTS OF JAPAN<br>vol. 13, no. 531 (E-851)( ) 28 November 1989,<br>& JP-A-01 216582 (FUJITSU) 30 August 1989,<br>* the whole document * | 6 | |
| | | | TECHNICAL FIELDS SEARCHED (Int. Cl.5 ) |

The present search report has been drawn up for all claims

| Place of search | Date of completion of the search | Examiner |
|---|---|---|
| BERLIN | 12 APRIL 1991 | ROUSSEL A.T. |